# EUROPEAN PATENT SPECIFICATION

(11) **EP 0 445 791 B1**
(45) Date of publication and mention of the grant of the patent: **25.10.1995**
(21) Application number: 91103439.5
(22) Date of filing: 06.03.1991
(51) Int. Cl.: C09D 163/00, C09D 7/12

(54) **Radiation curable protective coating composition containing epoxides and colloidal silica**
Strahlungshärtbare Schutzüberzugszusammensetzung enthaltend Epoxide und kolloidales Siliziumdioxid
Composition de revêtement protecteur durcissable par radiation contenant des époxydes et de la silice colloidale

(30) Priority: 07.03.1990 US 489635
(43) Date of publication of application: 11.09.1991
(73) Proprietor: DOW CORNING CORPORATION, Midland Michigan 48686-0994 (US)
(72) Inventor: Cottington, Levi James, Midland, Michigan (US)
(74) Representative: Spott, Gottfried, Dr.

(56) References cited:
- DE-A- 3 615 790
- US-A- 4 504 374
- DATABASE WPIL, no. 86-178 526, DERWENT PUBLICATIONS LTD., London, GB; & JP-A-61 110 549
- DATABASE WPIL, no. 86-128 586, DERWENT PUBLICATIONS LTD., London, GB; & JP-A-61 066 726

## Description

The present invention relates to an ultraviolet radiation curable protective coating composition. More specifically, this invention relates to a UV curable epoxide composition which can be used as a coating agent to enhance abrasion resistance and weather resistance of the surface of a solid substrate.

Epoxides have been incorporated into coating compositions to enhance hardness and abrasion resistance of the surface of molded products such as polycarbonates and polymethyl methacrylates. For example, U.S. Patent No. 4,525,421, issued June 25, 1985 discloses a hard coating composition containing an organic silicon compound, colloidal silica, a polyfunctional epoxy compound and magnesium perchlorate. Copending commonly assigned U.S. Patent Application Serial No. 06/796,055, filed November 7, 1989, further describes compositions useful as protective coatings on substrates containing epoxides and polyorganosiloxanes.

JP-A 61 110 549 discloses an ultraviolet curing composition which comprises a photopolymerisable epoxy compound having one or more epoxy groups and a photopolymerisation initiator. This coating can contain up to 8% finely divided silica. US-A 4 504 374 is concerned with a method of providing a stone chip-resistant finish to the undersurface of an automobile wherein a liquid mixture is applied which comprises a cationically curable polyepoxide, polyhydric alcohol and/or water, and a photoinitiator and/or a photosensitizer for an ultraviolet-activated cure. JP-A 61 066 726 teaches resin compositions comprising a photopolymerisable oligomer, a copolymerisable monomer and a photoinitiator together with colloidal silica. Moreover, from DE-A 36 15 790 a composition is known which comprises a polyfunctional epoxy oligomer, a finely divided unorganic filler, and a photoinitiator. The unorganic filler used has been treated with an organosilicon compound.

The present invention, however, has eliminated the need for organosilicon compounds in protective coating formulations which contain epoxides. In addition, when applied to a substrate and cured, the present invention forms a protective, abrasion resistant, weather resistant coating firmly held thereon.

This invention is directed to a solid substrate having at least one surface coated with an ultraviolet radiation curable coating composition, which is transparent to visible light, wherein the substrate is a plastic transparent to visible light, and wherein the ultraviolet curable coating composition comprises:
(A) 35 to 80 percent by weight of a cycloaliphatic epoxide having at least two epoxy groups per molecule;
(B) 15 to 60 percent by weight of colloidal silica and
(C) 2 to 3 percent by weight of a photosensitive onium salt as ultraviolet activated photoinitiator, wherein the composition is free of organosilicon compounds.

Accordingly, it is one object of the present invention to provide an abrasion resistant coating composition which contains an epoxide, colloidal silica and a photoinitiator.

It is another object of the present invention to provide an abrasion resistant coating composition in which either colloidal silica dispersed in an organic solvent or colloidal silica dispersed in an organic solvent and water combination may be used.

It is a further object of the invention to provide an improved abrasion resistant and weather resistant coating composition for solid substrates which is curable by ultraviolet light radiation.

The term epoxide includes those compounds with at least two epoxy groups per molecule, as well as, those which are polymeric such as the reaction products of epichlorohydrin and phenol or a phenolformaldehydide resin, diepoxy resins, epoxidized oils and epoxidized polyolefins. Preferably, the epoxides are cycloaliphatic epoxides. Suitable epoxides include those of the following formulae 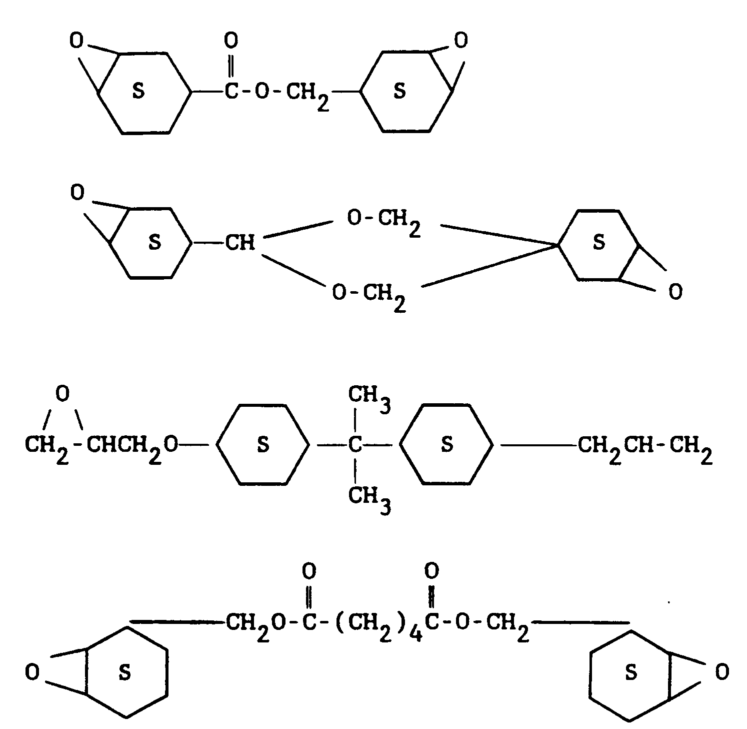
Some prefered examples of cycloaliphatic epoxides useable as component (A) include Cyracure® UVR-6100, UVR-6110, UVR-6379, UVR-6351 and UVR-6200, manufactured by Union Carbide Chemicals and Plastics Company Inc., Danbury, CT.

Colloidal silica useful in the present invention includes that which is dispersed in an organic solvent such as an alcohol, ether, ketone, ester or mixtures thereof and that which is dispersed in an organic solvent and water combination. Some preferred examples of colloidal silica usable as component (B) and available from Nalco Chemical Company, Naperville, IL., include Nalco 1129 colloidal silica and Nalco 84SS258 colloidal silica. Nalco 1129 colloidal silica has a mean particle size of 20 nanometers and an SiO₂ content of approximately 30% by weight in a solution of 40% isopropanol and 30% water. Nalco 84SS258 colloidal silica has a mean particle size of 20 nanometers and an SiO₂ content of approximately 30% by weight in a solution of propoxyethanol.

The third component is an ultraviolet-activated photoinitiator. Most preferably the photoinitiator is a photosensitive onium salt which is a catalyst activated by ultraviolet radiation which in turn initiates a cationic crosslinking process. The use of photosensitive onium salts to promote the cure of epoxides when exposed to ultraviolet radiation is described in U.S. Patent Nos. 4,058,401, 4,138,255 and 4,161,478, which are to teach the types of photosensitive onium salts and methods of using such to cure epoxides by ultraviolet radiation.

Examples of photosensitive onium salts useful to initiate the cationic crosslinking process in the present invention include triphenylsulfonium tetrafluorborate, triphenylselenonium hexafluoroborate, triphenylselenonium hexafluoro-arsenate, triphenylselenonium hexafluoroarsenate, triphenylsulfonium fluoroborate, S-phenyldibenzothiophenium fluoroborate, triphenylsulfonium hexafluororarsenate, S-phenylthioxanthene fluorobrate, phenacyltetramethylene sulfonium hexafluoroarsenate, triphenyl-sulfonium hexafluoroantimonate, tris-(3,5-dimethyl-4-hydroxy)phenyl sulfonium hexafluoroarsenate, triphenacyl hexafluoroarsenate and blends thereof. Specific examples of prefered photosensitive onium salts include Cyracure® UVI-6990 and UVI-6974, manufactured by Union Carbide Chemicals and Plastics Company Inc., Danbury, CT. Cyracure® UVI-6990 is an approximately equal weight mixture of triaryl sulfonium hexafluorophosphate salts and propylene carbonate. Cyracure® UVI-6974 is an approximately equal weight mixture of triaryl sulfonium hexafluoroantimonate salts and propylene carbonate.

The ingredients (A), (B) and (C) are combined to provide a composition which cures upon exposure to ultraviolet radiation through a cationic crosslinking mechanism. The ingredients are combined by mixing from 30 to 98 weight percent of the epoxide, 2 to 70 weight percent of the colloidal silica and 0.05 to 5 percent of the photoinitiator, wherein the combined percentages total 100 weight percent. Preferably the compositions are made from 35 to 80 weight percent (A), 15 to 60 weight percent (B) and 2 to 3 weight percent (C). In these compositions the preferred (A) is a cycloaliphatic epoxy resin, the preferred (B) is colloidal silica dispersed in an organic solvent and the preferred (C) is a triaryl sulfonium salt.

Many other ingredients can be added to the compositions of this invention to enhance the usefulness of the coatings. For example, leveling agents, such as Fluorad™ FC-171, available from Industrial Chemical Products Division/3M, St. Paul, MN., UV absorbers, dyes and solvents can be included herein. In addition, other epoxy compounds can be added, for example an epoxy compound which has only one epoxy group per molecule such as glycidyl methylether or glycidyl methacrylate. Diols may also be used as reactive diluents in the present invention. Any of these compounds can be used as long as they do not deleteriously effect either the curing or the transparency of the coating.

In the practice of the present invention, the radiation curable compositions can be made by combining the epoxides, colloidal silica and photoinitiator. The compositions are coated on a substrate using conventional coating techniques modified as appropriate to the particular substrate. For example, these compositions can be applied to a variety of solid substrates by methods such as roller coating, flow coating, dip coating, spin coating, spray coating, rod coating and curtain coating. These various methods of coating allow the compositions to be placed on a substrate at variable thicknesses thus allowing a wider range of use of the compositions. Coating thicknesses may vary, but for improved abrasion resistance coating thicknesses 2-25 microns, or about 5 microns, are preferred.

After the coating composition is applied to a substrate, the composition may be cured thereon by an effective amount of UV radiation, such as that emitted, for example, from a Fusion UV Curing Systems Model F450-20, available from Fusion UV Curing Systems, Rockville, MA.

The coating compositions of this invention will cure on a substrate after being exposed to radiation such as that provided by UV lamps. To speed up the cure process initiated by UV radiation, a prefered method of the present invention involves exposing the coated substrate to heat for 15 to 60 minutes at a temperature from about 50°C. to about 170°C. Preferred temperatures for metal, polycarbonate and acrylic type substrates are 160°C., 125°C. and 85°C. respectively.

Substrates which are especially contemplated herein are transparent plastics. More particularly, these plastics are acrylic polymers, such as poly(methylmethacrylate); polyesters, such as poly(ethylene terephthalate) and poly (butylene terephthalate); polyamides; polyimides; acrylonitrile-styrene copolymers; styrene-acrylonitrile-butadiene copolymers; polyvinyl chloride; butyrates; polyethylene and polyolefins. The coating compositions of this invention are especially useful as coatings for those polycarbonates known as Lexan^{R}, available from General Electric Company, Schenectady, NY. and acrylics known as Plexiglass® G, available from Rohm and Haas Company, Inc., Philadelphia, PA.

The apparatus and testing procedures used herein are as follows:
Abrasion resistance was determined according to ASTM Method D-1044 (known as the "Tabor Test"). The instrument used was a Teledyne Taber model 503 Tabor Abraser with two 250 gram auxiliary weights (500 gram load) for each of the CS10F abrasive wheels. The test panels were subjected to 100 and 500 cycles on the abraser turntable. The percent change in haze which is the criterion for determining the abrasion resistance of the coating is determined by measuring the difference in haze of the unabrased and abrased coatings. Haze is defined as the percentage of transmitted light which, in passing through the sample, deviates from the incident beam by forward scattering. In this method, only light flux that deviates more than 2.5 degrees on the average is considered to be haze. The percent haze on the coatings was determined by ASTM Method D1003. A Gardner Haze Meter was used. The haze was calculated by measuring the amount of diffused light, dividing by the amount of transmitted light and multiplying by one hundred.

Adhesion was measured by modified ASTM-D-3002 (cross-hatch adhesion). The coated test specimen was scribed with a razor, cutting through the coating to form a series of cross-hatch scribes in an area of one square inch with lines to form 1/10 inch squares. Clear cellophane tape (3M No. 600 preferred), was applied to the scribed surface, pressed down, then stripped sharply away in a direction perpendicular to the test panel surface. The first tape pull was followed by two more, using fresh tape each time. After three tape pulls, the number of squares remaining intact on the specimen was reported as a percentage of the total number of squares on the grid.

The Pencil test is a qualitative method of determining scratch resistance of a coating. A coated panel was placed on a firm horizontal surface. A pencil was held firmly against the film at a 45° angle (point away from the operator) and pushed away from the operator in a 1/4-in. (6.5-mm) stroke. The process is started with the hardest lead pencil and continued down the scale of hardness to the pencil that will not cut into or gouge the film. The hardest pencil that will not cut through the film to the substrate for a distance of at least 1/8 in. (3mm) is reported according to the following scale from Berol Corporation, Brentwood, TN.: 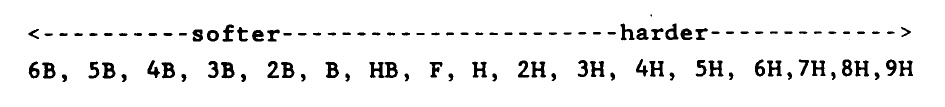
The HB grade is approximately equal to that of a #2 pencil. The F grade is slightly harder and is the one most commonly used. The H grades are harder and get progressively harder up through the 9H grade which is very hard. The B grade is softer than the HB grade and gets progressively softer through the 6B grade which is very soft.

In the Steel Wool test, two inch square of No. 0000 steel wool was applied over the face of a 24 oz. hammer and was secured with a rubber band. Coated samples were tested for scratch resistance to 20 double rubs across the center of the sample with the weighted steel wool. The hammer was held by the end of its handle such that the majority of the pressure on the steel wool comes from the hammer head. The samples were graded according to the amount of scratching produced by the steel wool and hammer. The absence of scratches on a sample is graded 1; slight scratching is graded 2 and heavy scratching is graded 3.

The invention will be further illustrated by a consideration of the following examples, which are intended to be exemplary of the invention. All parts and percentages in the examples are on a weight basis unless otherwise stated.

### Example 1

A mixture of 32.96 g of Cyracure® UVR-6110, 17.04 g of UVR-6100, 8.05 g of UVR-6379, 3.0 g of UVI-6974, 0.5 g of Fluorad™ FC-171 and 20.0 g of Nalco 84SS258 colloidal silica, was prepared in a cold blend. The mixture was flow coated onto a 3 X 5 X 1/16 inch aluminum panel and allowed to air dry for five minutes. The sample was UV cured in a Fusion UV Curing Systems Model F450-20 by one pass under two adjacent ten inch 300 watt per inch bulbs, at a belt speed of 15 feet per minute wherein the distance between the bulbs and the belt was 4.1 inches. The sample was heated for 30 minutes at 160°C. The test results are summarized in Table I.

**TABLE I**

| **Properties of Coated Polycarbonate** | | | | | |
|---|---|---|---|---|---|
| Coating Compositions | ADHESION TEST | STEEL WOOL | PENCIL TEST | ABRASION | |
| | | | | %H₁₀₀ | %H₅₀₀ |
| Example 1 | 100% | 2 | 3H | --- | --- |

The results in Table I indicate that coating compositions containing epoxides having at least two epoxy groups per molecule, colloidal silica and a cationic photoinitiator readily adhere to and form improved transparent and abrasion resistant coatings on plastic and metal substrates following exposure to UV radiation.

## Claims

1. A solid substrate having at least one surface coated with on ultraviolet radiation curable coating composition, which is transparent to visible light, wherein the substrate is a plastic transparent to visible light, and wherein the ultraviolet curable coating composition comprises:
(A) 35 to 80 percent by weight of a cycloaliphatic epoxide having at least two epoxy groups per molecule;
(B) 15 to 60 percent by weight of colloidal silica and
(C) 2 to 3 percent by weight of a photosensitive onium salt as ultraviolet activated photoinitiator, wherein the composition is free of organosilicon compounds.

2. The substrate of claim 1 wherein component (B) is dispersed in an organic solvent.

3. The substrate of claim 2 wherein water is also present.

## Patentansprüche

1. Festes Substrat, bei dem mindestens eine Oberfläche mit einer durch Ultraviolettstrahlung härtbaren Beschichtungszusammensetzung beschichtet ist, die für sichtbares Licht durchlässig ist, wobei das Substrat ein Kunststoff ist, der für sichtbares Licht durchlässig ist und wobei die durch Ultraviolettstrahlung härtbare Beschichtungszusammensetzung umfaßt:
(A) 35 bis 80 Gewichtsprozent eines cycloaliphatischen Epoxids mit mindestens zwei Epoxygruppen pro Molekül;
(B) 15 bis 60 Gewichtsprozent kolloidales Siliciumdioxid und
(C) 2 bis 3 Gewichtsprozent eines lichtempfindlichen Oniumsalzes als durch Ultraviolettstrahlung aktiviertem Photoinitiator, wobei die Zusammensetzung frei ist von Organosiliciumverbindungen.

2. Substrat nach Anspruch 1, worin die Komponente (B) in einem organischen Lösungsmittel dispergiert ist.

3. Substrat nach Anspruch 2, worin auch Wasser vorhanden ist.

## Revendications

1. Un substrat solide dont au moins une surface est revêtue d'une composition de revêtement durcissable par irradiation ultraviolette, qui est transparente à la lumière visible, dans lequel le substrat est une matière plastique transparente à la lumière visible, et dans lequel la composition de revêtement durcissable par irradiation ultraviolette comprend :
(A) 35 à 80 pour cent en poids d'un époxyde cycloaliphatique ayant au moins deux groupes époxy par molécule ;
(B) 15 à 60 pour cent en poids de silice colloïdale et
(C) 2 à 3 pour cent en poids d'un sel d'onium photosensible comme photo-initiateur activé par la lumière ultraviolette, la composition étant exempte de composés organosiliciés.

2. Le substrat de la revendication 1, dans lequel le composant (B) est dispersé dans un solvant organique.

3. Le substrat de la revendication 2, dans lequel de l'eau est également présente.
